Europäisches Patentamt

European Patent Office

Office européen des brevets

(19)

(11) **EP 0 618 308 B1**

(12) **EUROPEAN PATENT SPECIFICATION**

(45) Date of publication and mention
of the grant of the patent:
**17.06.1998 Bulletin 1998/25**

(51) Int Cl.$^6$: **C23C 18/44**

(21) Application number: **94302159.2**

(22) Date of filing: **25.03.1994**

(54) **Electroless gold plating bath**

Nichtelektrolytische Goldplattierlösung

Bain de dépôt chimique d'or

(84) Designated Contracting States:
**DE FR GB NL**

(30) Priority: **26.03.1993 JP 92202/93**

(43) Date of publication of application:
**05.10.1994 Bulletin 1994/40**

(73) Proprietor: **C. UYEMURA & CO, LTD**
**Osaka-shi Osaka (JP)**

(72) Inventors:
- **Tsujimoto, Masanobu, c/o Chuo Kenkyujo**
  **Hirakata-shi, Osaka (JP)**
- **Morimoto, Keizin, c/o Chuo Kenkyujo**
  **Hirakata-shi, Osaka (JP)**
- **Yanada, Isamu, c/o Chuo Kenkyujo**
  **Hirakata-shi, Osaka (JP)**
- **Murakami, Tooru, c/o Chuo Kenkyujo**
  **Hirakata-shi, Osaka (JP)**

(74) Representative: **Lyons, June Margaret et al**
**MEWBURN ELLIS,**
**York House,**
**23 Kingsway**
**London WC2B 6HP (GB)**

(56) References cited:
EP-A- 0 272 100     EP-A- 0 281 804
EP-A- 0 630 991     FR-A- 2 441 666

**Description**

This invention relates to an electroless or chemical gold plating bath and more particularly, to an electroless gold plating bath comprising a water-soluble gold compound, a complexing agent, a reducing agent, and a stabilizer for minimizing plating spread.

For utilizing the advantages of gold including its physical properties such as electric conduction and thermal bonding ability and its chemical properties such as oxidation resistance and chemical resistance, electroless gold plating has heretofore been applied to terminals and circuit surfaces of electronic industry parts including printed circuit boards, ceramic IC packages, ITO substrates, and IC cards.

Conventional electroless gold plating baths, however, tend to incur plating spread in that a coating also deposits at non-intended places, causing stains or blur, especially in the case of plating on metal portions formed on a ceramic base. The plating spread is a serious problem particularly when it is desired to effect electroless gold plating on ceramic IC packages.

Therefore, an object of the present invention is to provide an electroless gold plating bath which when applied to a ceramic base having metal portions thereon, can form a satisfactory gold coating only on the metal portions without incurring plating spread and is thus suited for gold plating of ceramic IC packages or the like.

Regarding an electroless or chemical plating bath comprising a water-soluble gold compound, a complexing agent, and a reducing agent, the inventors have found that by adding a non-ionic surfactant or a non-ionic polymer such as polyalkylene glycols, polyalkylene glycol type surfactants, polyvinyl alcohol, and polyvinyl pyrrolidone as a plating stabilizer to the bath, an aesthetically acceptable gold plating film free of stain or blur can be deposited on metal portions on a ceramic base without incurring plating spread.

The present invention provides an electroless gold plating bath comprising a water-soluble gold compound, a complexing agent, a reducing agent, and a stabilizer in the form of a non-ionic surfactant or a non-ionic polymer.

The present invention also provides a method of electroless gold plating a metal portion on a ceramic base wherein the ceramic base is immersed in the above-defined electroless gold plating bath thereby the gold coating is deposited only on the metal portion.

EMBODIMENTS OF THE INVENTION

A water-soluble gold compound is contained as a gold source in the electroless gold plating bath of the invention. It is any of gold compounds which can provide monovalent and trivalent gold ions in the plating bath. Useful examples include sodium gold sulfite, potassium gold sulfite, ammonium gold sulfite, sodium gold cyanide, potassium gold cyanide, sodium chloroaurate, and potassium chloroaurate.

The water-soluble gold compound concentration is 1 to 20 grams/liter, especially 2 to 8 grams/liter of gold ion. In general, the plating rate increases in substantial proportion to the amount of the water-soluble gold compound blended, that is, the concentration of gold ion in the plating bath. Concentrations in excess of 20 grams/liter are less desirable despite an increased plating rate because the plating bath would become less stable and the drag-out of the expensive gold compound is increased against economy. On the other hand, the plating rate is very low at gold ion concentrations below 1 grams/liter of gold ion.

The complexing agent may be any of well-known ones. Useful complexing agents are sodium sulfite, potassium sulfite, ammonium sulfite, sodium cyanide, potassium cyanide, sodium thiosulfate, potassium thiosulfate, ammonium thiosulfate, EDTA, nitrilotriacetic acid (NTA), organic phosphonic acids and salts thereof, citric acid and salts thereof, tartaric acid and salts thereof, glucono-δ-lactone, gluconates, and essential amino acids and salts thereof. Preferred examples of the organic phosphonic acid include aminotri(methylenephosphonic acid) and salts thereof, 1-hydroxyethylidene-1,1-diphosphonic acid and salts thereof, ethylenediaminetetra(methylenephosphonic acid) and salts thereof, and diethylenetriaminepenta(methylenephosphonic acid) and salts thereof, with sodium, potassium and ammonium salts being the preferred salts.

The complexing agent concentration is 5 to 200 grams/liter, especially 20 to 150 grams/liter. Less than 5 grams/liter of the complexing agent would be less effective whereas more than 200 grams/liter of the complexing agent would provide no further advantage and is thus uneconomical.

Examples of the reducing agent include hydrazines such as hydrazine hydrate, hydrazine sulfate, neutral hydrazine sulfate, and hydrazine maleate, salts of the hydrazines, hydrazine derivatives such as hydroxylamine, ascorbic acid and sodium, potassium and ammonium salts thereof, trimethylamineborane (TMAB), dimethylamineborane (DMAB).

The reducing agent is effective for causing gold ions in the plating bath to deposit on an article to be plated. The reducing agent concentration is 1 to 100 grams/liter, especially 5 to 70 grams/liter. In general, the plating rate increases in substantial proportion to the concentration of the reducing agent. More than 100 grams/liter of the reducing agent would be less effective for accelerating the plating rate and rather render the plating bath less stable. Plating rate becomes very slow below 1 grams/liter of the reducing agent.

To a plating bath containing the above-mentioned water-soluble gold compound, complexing agent and reducing agent, a non-ionic surfactant and/or a non-ionic polymer is added as a stabilizer for restraining plating spread according to the present invention.

Examples of the non-ionic surfactant include polyalkylene glycols having a molecular weight of 200 to 9,000, preferably 500 to 4,000 such as polyethylene glycol (PEG) and polypropylene glycol (PPG), typically PEG-4000, PEG-1540, PPG-1000 and PEG-600. Examples of the non-ionic polymer include polyvinyl alcohol, e.g., Gosenol NL-05 commercially available from The Nippon Synthetic Chemical Industry Co., Ltd. and polyvinyl pyrrolidone, e.g., K-12, K-15, K-30, K-60, and K-90 commercially available from Kishida Reagents Chemical Co., Ltd.

These non-ionic surfactant and polymer stabilizers may be used alone or in admixture of two or more. The addition amount is suitably selected depending on a particular type of stabilizer to be 0.1 to 100 mg/liter, especially 0.3 to 30 mg/liter of the stabilizer is preferred. Below the range, the stabilizer may not be effective for restraining plating spread. Too much of the stabiliser may slow down the plating rate.

Several advantages are obtained from the addition of the stabilizer. Even when an article to be plated is a metal portion formed on a ceramic substrate, the stabilizer ensures that a satisfactory gold coating is deposited only on the metal portion without incurring plating spread. The stabilizer is also effective for preventing decomposition of the plating solution. Although the mechanism of the stabilizer achieving such advantages is not well understood, we have the following hypotheses.

One probable presumption is that the stabilizer is adsorbed to a gold plating film or gold colloid particles resulting from solution decomposition, thereby preventing gold deposition on the non-metal portion. A certain mechanism allows plating to proceed on the plating film, but not on the gold colloid particles, thereby preventing solution decomposition and plating spread. An alternative presumption is that the stabilizer is adsorbed to a ceramic portion of an article to prevent gold deposition thereon. That is, the stabilizer is selectively adsorbed to the ceramic rather than to the gold plating film to prevent plating spread. A further presumption is that since gold colloid particles have a remarkably larger surface area per unit volume than the plating surface, the stabilizer prevents plating spreads by selectively preventing growth of gold colloid to restrain decomposition of the plating solution and by preventing gold colloid particles resulting from solution decomposition from being adsorbed to the ceramic to form nuclei from which plating grows.

In addition to the water-soluble gold compound, complexing agent, reducing agent, and stabilizer, the electroless gold plating bath of the invention may further contain a nitrogenous compound which is effective for increasing the plating rate.

Examples of the nitrogenous compound used include ammonia, aminocarboxylic acids, iminocarboxylic acids, other water-soluble nitrogen-containing organic compounds and salts thereof. Examples of the ammonia and salts thereof include aqueous ammonia, ammonium sulfate, ammonium chloride, ammonium acetate, and ammonium nitrate. Examples of the aminocarboxylic acid include essential amino acids and examples of the iminocarboxylic acid are ethylenediaminetetraacetic acid and nitrilotriacetic acid. Examples of the other water-soluble nitrogen-containing organic compound include amines such as ethylenediamine, diethylenetriamine, triethylenetetramide, tetraethylenepentamine, hexamethylenetetramine, and guanidine; aminoalcohols such as mono-ethanolamine, diethanolamine, and triethanolamine; aromatic amines such as p-methylaminophenol, aminophenol, phenylenediamine, and aminobenzoic acid; heterocyclic compounds such as imidazole, uracil, morpholine, and pyrazine; nitrogenous sulfonic acids such as bis(hydroxyethyl)aminoethanesulfonic acid, metanilic acid, anthranilic acid, pyridine-sulfonic acid, 8-hydroxyquinoline-5-sulfonic acid, and taurine; and pyridines such as dipyridyl, picolinic acid, and dihydroxypyridine. Preferred water-soluble nitrogenous organic compounds are aromatic amines such as p-methylaminophenol and aminophenol though not limited thereto. The amount of the nitrogenous compound added is suitably selected depending on its type or the like and not critical. For ammonia and analogs, the amount is 1 to 200 grams/liter, especially 5 to 150 grams/liter. For the aminocarboxylic acids, iminocarboxylic acids and other water-soluble nitrogen-containing organic compounds, the amount is 0.01 to 100 grams/liter, especially 0.05 to 50 grams/liter.

A water-soluble lead compound such as lead acetate, lead nitrate and lead methanesulfonate and/or a water-soluble thallium compound such as thallium sulfate may be added to the plating bath of the present invention to incorporate a lead ion and/or thallium ion therein for increasing the plating rate and improving the crystalline state of a deposit coating. The amount of the water-soluble lead compound and/or thallium compound added is preferably 0.1 to 50 mg/liter, especially 0.5 to 30 mg/liter calculated as metal ion. Less than 0.1 mg/liter of the lead or thallium ion may not be effective whereas more than 50 mg/liter may provide only a slight increase of its effect and sometimes result in a plating film of uneven appearance.

When it is desired to plate gold on a copper substrate using the plating bath of the invention, a copper ion can be leached into the bath and gold deposition can take place where copper ion leaching has took pace. To prevent the copper leaching, the plating bath may further contain benzotriazole and/or cyanide ion ($CN^-$) where the plating bath is free of cyanide ion. Benzotriazole is adsorbed on copper or form a water-insoluble chelate with a copper ion for preventing dissolution of a copper ion. Although the interaction mechanism of cyanide ion is not well understood, it is presumed that $Cu^+$ and $CN^-$ form a complex to decrease the reducing power of $Cu^+$.

Although the amount of benzotriazole added is not critical, it is preferably 0.001 to 10 grams/liter, especially 0.01 to 1 gram/liter. Less than 0.001 gram/liter of benzotriazole may not be effective whereas more than 10 gram/liter may provide only a slight increase of its effect and sometimes lower the plating rate. A cyanide ion is added where the water-soluble gold compound and complexing agent used are compounds other than cyanides, for example, such as gold sulfite and sodium sulfite. Although the amount of cyanide added is not critical, it is about 0.01 to 2 grams/liter, especially 0.05 to 1 gram/liter. Less than 0.01 gram/liter of cyanide may not be effective whereas more than 2 grams/liter may cause a substantial lowering of plating rate. The cyanide source for supplying a cyanide ion to the plating bath includes NaCN, KCN, $Na[Au(CN)_2]$ and $K[Au(CN)_2]$.

When plating is carried out using the electroless gold plating bath of the invention, an article to be plated such as a printed circuit board and ceramic IC package is immersed in the bath. The printed circuit board and ceramic IC package are preferably those having an electroless plating Ni/B film and/or an electroless plating Ni/P film formed thereon and a gold replacement plating film formed further thereon although the invention is not limited thereto.

Next the plating conditions are described. The plating bath may have a pH of 3 to 14, especially 4 to 14 depending on the type of reducing agent or the like. The preferred pH range varies with a particular type of reducing agent. For example, nearly neutral pH levels (pH 6 to 9) are preferred for ascorbic acid, analogs, strongly alkaline pH levels (pH 10 to 14) are preferred for TMAB, DMAB and analogs, and neutral to alkaline pH levels (pH 6 to 14) are preferred for hydrazines.

The plating temperature or bath temperature is preferably about 40 to 90°C, especially about 50 to 80°C. The plating rate may be too low at temperatures lower than 40°C. At temperature above 90°C, plating stability may be lost despite an increased plating rate. The plating solution may be agitated. A mechanism of striking an article to be plated by a hammer is preferably set to prevent generation of gas pits. The solution may be filtered batchwise or by circulation. Preferably the plating solution is pumped and circulated through a filter for eliminating temperature variation of the solution and removing solid debris from the solution. Vigorous agitation of the plating solution can retard plating, resulting in a low plating rate. Therefore, agitation of the plating solution, circulation of the plating solution for filtering and rocking of an article to be plated should preferably be moderate.

It is also possible to introduce air into the plating bath because air introduction is effective for preventing generation of gold colloid particles or gold particles in the bath. Although the effect of air introduction is not well understood, it is presumed that Au can be effectively dissolved by $SO_3^{2-}$ in the presence of $O_2$ through a mechanism similar to the well-known reaction:

$$CN^- + O_2 + Au \rightarrow Au^+$$

where a gold sulfite salt and a sulfite are used. Where copper is the underlying metal, it is presumed that although copper can be leached into the plating solution to generate gold particles through the reaction:

$$Au^+ + Cu^+ \rightarrow Au \downarrow + Cu^{2+},$$

$Cu^+$ generated as a result of leaching is oxidized by $O_2$ into non-harmful $Cu^{2+}$. Although it is unknown whether or not the above-mentioned reaction $Au^+ + Cu^+ \rightarrow Au \downarrow + Cu^{2+}$ proceeds, it was empirically found that Au deposited where Cu leaching occurred.

Air can be introduced into the plating bath by blowing air therein. Then the procedure of agitating the plating bath may be air agitation whereby air is introduced at the same time as agitation. Alternatively air may be blown into the bath separately from agitation. Preferably air is blown into the plating bath so as to avoid direct contact with the surface being plated. To this end, an air partition may be disposed in the plating bath. If air directly contacts the surface being plated, solution flow at the plating interface becomes faster and uneven, resulting in inconveniences such as uneven color and uneven thickness of the plating film and a lowering of plating rate.

A plating rate of about 0.1 to about 5 μm/hr. is generally available with the electroless gold plating bath of the invention. Self catalysis is expected when a plating film is formed on a gold plate (gold plating film). By replenishing the gold source and reducing agent for their consumption, the bath can be used about 5 turns (5 × M grams/liter wherein M is a gold ion concentration at the initial bath).

EXAMPLE

Examples of the present invention are given below by way of illustration and not by way of limitation.

## Example 1

The article to be plated was an IC package which was prepared from an alumina substrate having a metallized pattern thereon by forming an electroless plating Ni-B film of 1 μm thick thereon, forming an electroless plating Ni-P film of 2 μm thick thereon, and forming a replacement plating gold film of 0.1 μm thick thereon. The IC package was immersed in a plating bath of the following composition wherein electroless gold plating was carried out under the following conditions. The plating rate was 3 μ m/hr.

| Plating bath composition | |
|---|---|
| Sodium gold sulfite | 4 g/l as monovalent gold ion |
| Sodium sulfite | 70 g/l |
| EDTA - 2Na | 45 g/l |
| Rochelle salt | 30 g/l |
| Hydrazine hydrate | 12 g/l |
| Polyvinyl alcohol* | 0.5 mg/l |
| pH | 10 |

*Gosenol NL- 05, The Nippon Synthetic Chemical Industry Co., Ltd.

| Plating conditions | |
|---|---|
| Temperature | 70°C |
| Solution volume | 500 ml |
| Agitation | air agitation |
| Time | 40 min. |

At the end of plating, the IC package was inspected to find no plating spread. It was fully susceptible to gold wire bonding and die bonding.

## Example 2

An IC package was subjected to electroless gold plating by the same procedure as in Example 1 except that 0.8 g/l of sodium thiosulfate, 2 g/l of ethylenediamine and 35 g/l of dipotassium monohydrogen citrate were added to the plating bath of Example 1. The plating rate was 3.5 μm/hr.

At the end of plating, the IC package was inspected to find no plating spread. It was fully susceptible to gold wire bonding and die bonding.

## Example 3

The same IC package as used in Example 1 was immersed in a plating bath of the following composition wherein electroless gold plating was carried out under the following conditions. The plating rate was 2 μm/hr.

| Plating bath composition | |
|---|---|
| Potassium gold cyanide | 4 g/l as monovalent gold ion |
| Potassium cyanide | 4 g/l |
| KOH | 10 g/l |
| Triethanolamine | 10 g/l |
| Dimethylamineborane | 2 g/l |
| Polyvinyl pyrrolidone (K-15) | 1 mg/l |
| Lead acetate | 2 mg/l as lead ion |
| pH | 14 |

| Plating conditions | |
|---|---|
| Temperature | 60°C |
| Solution volume | 500 ml |
| Agitation | cathode rocking, 1 m/min. |
| Time | 60 min. |

At the end of plating, the IC package was inspected to find no plating spread. It was fully susceptible to gold wire bonding and die bonding.

### Example 4

The same IC package as used in Example 1 was immersed in a plating bath of the following composition wherein electroless gold plating was carried out under the following conditions. The plating rate was 1 $\mu$m/hr.

| Plating bath composition | |
|---|---|
| Sodium gold sulfite | 4 g/l as monovalent gold ion |
| Sodium sulfite | 20 g/l |
| Sodium thiosulfate | 20 g/l |
| Sodium ascorbate | 2 g/l |
| Polyethylene glycol (PEG-4000) | 1 mg/l |
| pH | 6 |

| Plating conditions | |
|---|---|
| Temperature | 60°C |
| Solution volume | 500 ml |
| Agitation | cathode rocking, 1 m/min. |
| Time | 60 min. |

At the end of plating, the IC package was inspected to find no plating spread. It was fully susceptible to gold wire bonding and die bonding.

### Comparative Example 1

Using the same plating bath as in Example 1 except that polyvinyl alcohol was omitted, an IC package was subjected to electroless gold plating by the same procedure as in Example 1. At the end of plating, the IC package was inspected to find plating spread, that is, the plating film extended beyond the requisite area.

### Comparative Example 2

Using the same plating bath as in Example 3 except that polyvinyl pyrrolidone was omitted, an IC package was subjected to electroless gold plating by the same procedure as in Example 3. At the end of plating, the IC package was inspected to find plating spread, that is, the plating film extended beyond the requisite area.

There has been described an electroless gold plating bath which contains a specific stabilizer for ensuring that a satisfactory gold plating film is formed on metal portions on a ceramic substrate as in ceramic IC package without plating spread.

Although some preferred embodiments have been described, many modifications and variations may be made thereto in the light of the above teachings. It is therefore to be understood that within the scope of the appended claims, the invention may be practised otherwise than as specifically described.

**Claims**

1. An electroless gold plating bath comprising

   (a) water-soluble gold compound, at from 1 to 20 g/l gold ion;
   (b) complexing agent, at from 5 to 200 g/l;
   (c) reducing agent selected from hydrazines, ascorbic acid and its water-soluble sodium, potassium and ammonium salts, trimethylamineborane and dimethylamineborane, at from 1 to 100 g/l, and
   (d) stabilizer selected from polyalkylene glycols having a molecular weight in the range 200 to 9000, polyvinyl alcohol and polyvinyl pyrrolidone, at from 0.1 to 100 mg/l.

2. A bath according to claim 1 containing from 0.3 to 30 mg/l of the stabiliser.

3. A bath according to claim 1 or claim 2 in which the water-soluble gold compound is selected from sodium gold sulphite, potassium gold sulphite, ammonium gold sulphite, sodium gold cyanide, potassium gold cyanide, sodium chloroaurate and potassium chloroaurate.

4. A bath according to any one of the preceding claims in which the water-soluble gold compound is present at from 2 to 8 g/l gold ion.

5. A bath according to any one of the preceding claims in which the complexing agent is selected from sodium sulphite, potassium sulphite, ammonium sulphite, sodium cyanide, potassium cyanide, sodium thiosulphate, potassium thiosulphate, ammonium thiosulphate, EDTA, nitrilotriacetic acid, organic phosphonic acids and salts thereof, citric acid and salts thereof, tartaric acid and salts thereof, glucono-δ-lactone, gluconates, and essential amino acids and salts thereof.

6. A bath according to any one of the preceding claims in which the complexing agent is present at from 20 to 150 g/l.

7. A bath according to any one of the preceding claims in which the reducing agent is present at from 5 to 70 g/l.

8. A bath according to any one of the preceding claims which comprises a nitrogenous compound.

9. A bath according to claim 8 in which the nitrogenous compound is selected from

   - ammonia and ammonium salts, at from 1 to 200 g/l;
   - water-soluble aminocarboxylic acids, iminocarboxylic acids, amines, aminoalcohols, aromatic amines, heterocyclic compounds, nitrogenous sulphonic acids and pyridines, at from 0.01 to 100 g/l.

10. A bath according to any one of the preceding claims which contains lead ion and/or thallium ion.

11. A bath according to claim 10 in which the lead ion and/or thallium ion is present at from 0.1 to 50 mg/l.

12. A bath according to any one of the preceding claims in which the water-soluble gold compound is not cyanide, the bath further comprising from 0.01 to 2 g/l cyanide ion.

13. A method of electroless gold plating in which a metal portion on a ceramic base is immersed in a bath according to any one of the preceding claims to deposit a gold coating on the metal portion.

14. In a method comprising electroless gold plating onto a metal portion on a ceramic base, from a bath comprising

   (a) water-soluble gold compound, at from 1 to 20 g/l gold ion;
   (b) complexing agent, at from 5 to 200 g/l; and
   (c) reducing agent selected from hydrazines, ascorbic acid and its water-soluble salts, trimethylamineborane and dimethylamineborane, at from 1 to 100 g/l,

   the use of

   (d) stabiliser selected from polyalkylene glycols having a molecular weight in the range 200 to 9000, polyvinyl alcohol and polyvinyl pyrrolidone, at from 0.1 to 100 mg/l, to restrain spread of the resulting gold plating from the metal portion onto the ceramic base.

**Patentansprüche**

1. Bad zum chemischen Vergolden, umfassend:

   (a) eine wasserlösliche Goldverbindung in einer Goldionen-Konzentration von 1 bis 20 g/l;
   (b) einen Komplexbildner in einer Konzentration von 5 bis 200 g/l;
   (c) ein Reduktionsmittel, ausgewählt aus Hydrazinen, Ascorbinsäure und deren wasserlöslichen Natrium-, Kalium- und Ammoniumsalzen, Trimethylaminboran und Dimethylaminboran, in einer Konzentration von 1 bis 100 g/l, und
   (d) einen Stabilisator, ausgewählt aus Polyalkylenglykolen mit einem Molekulargewicht im Bereich von 200 bis 9.000, Polyvinylalkohol und Polyvinylpyrrolidon, in einer Konzentration von 0,1 bis 100 mg/l.

2. Bad nach Anspruch 1, das 0,3 bis 30 mg/l des Stabilisators enthält.

3. Bad nach Anspruch 1 oder 2, worin die wasserlösliche Goldverbindung aus Natriumgoldsulfit, Kaliumgoldsulfit, Ammoniumgoldsulfit, Natriumgoldcyanid, Kaliumgoldcyanid, Natriumchloraurat und Kaliumchloraurat ausgewählt ist.

4. Bad nach einem der vorangegangenen Ansprüche, worin die wasserlösliche Goldverbindung in einer Goldionen-Konzentration von 2 bis 8 g/l vorhanden ist.

5. Bad nach einem der vorangegangenen Ansprüche, worin der Komplexbildner aus Natriumsulfit, Kaliumsulfit, Ammoniumsulfit, Natriumcyanid, Kaliumcyanid, Natriumthiosulfat, Kaliumthiosulfat, Ammoniumthiosulfat, EDTA, Nitrilotriessigsäure, organischen Phosphonsäuren und Salzen davon, Zitronensäure und Salzen davon, Weinsäure und Salzen davon, Glucono-δ-lacton, Gluconaten und essentiellen Aminosäuren und Salzen davon ausgewählt ist.

6. Bad nach einem der vorangegangenen Ansprüche, worin der Komplexbildner in einer Konzentration von 20 bis 150 g/l enthalten ist.

7. Bad nach einem der vorangegangenen Ansprüche, worin das Reduktionsmittel in einer Konzentration von 5 bis 70 g/l enthalten ist.

8. Bad nach einem der vorangegangenen Ansprüche, das eine stickstoffhältige Verbindung umfaßt.

9. Bad nach Anspruch 8, worin die stickstoffhältige Verbindung ausgewählt ist aus

   - Ammoniak- und Ammoniumsalzen in einer Konzentration von 1 bis 200 g/l;
   - wasserlöslichen Aminocarbonsäuren, Iminocarbonsäuren, Aminen, Aminoalkoholen, aromatischen Aminen, heterozyklischen Verbindungen, stickstoffhältigen Sulfonsäuren und Pyridinen in einer Konzentration von 0,01 bis 100 g/l.

10. Bad nach einem der vorangegangenen Ansprüche, das Blei- und/oder Thalliumionen enthält.

11. Bad nach Anspruch 10, worin die Blei- und/oder Thalliumionen in einer Konzentration von 0,1 bis 50 mg/l enthalten sind.

12. Bad nach einem der vorangegangenen Ansprüche, bei dem die wasserlösliche Goldverbindung nicht Cyanid ist, wobei das Bad weiters Cyanidionen in einer Konzentration 0,01 bis 2 g/l umfaßt.

13. Verfahren zum chemischen Vergolden, worin ein Metallabschnitt auf einer Keramikbasis in ein Bad nach einem der vorangegangenen Ansprüche getaucht wird, um einen Goldüberzug auf dem Metallabschnitt abzulagern.

14. Verwendung in einem Verfahren, umfassend das chemische Vergolden eines Metallabschnitts auf einer Keramikbasis mit einem Bad, das

(a) eine wasserlösliche Goldverbindung in einer Goldionen-Konzentration von 1 bis 20 g/l;

(b) einen Komplexbildner in einer Konzentration von 5 bis 200 g/l;

(c) ein Reduktionsmittel, ausgewählt aus Hydrazinen, Ascorbinsäure und deren wasserlöslichen Salzen, Trimethylaminboran und Dimethylaminboran, in einer Konzentration von 1 bis 100 g/l, umfaßt,

(d) eines Stabilisators, ausgewählt aus Polyalkylenglykolen mit einem Molekulargewicht im Bereich von 200 bis 9.000, Polyvinylalkohol und Polyvinylpyrrolidon, in einer Konzentration von 0,1 bis 100 mg/l, um die Ausbreitung des erhaltenen Goldüberzugs vom Metallabschnitt auf die Keramikbasis zu hemmen.

## Revendications

1. Bain de placage d'or non électrolytique comprenant

   (a) un composé d'or soluble dans l'eau, à raison de 1 à 20 g/l de l'ion d'or;

   (b) un agent complexant, à raison de 5 à 200 g/l;

   (c) un agent réducteur sélectionné parmi des hydrazines, l'acide ascorbique et ses sels de sodium, potassium et ammonium solubles dans l'eau, le triméthylamineborane et le diméthylamineborane, à raison de 1 à 100 g/l, et

   (d) un stabilisant sélectionné parmi les polyalkylène glycols ayant un poids moléculaire compris entre 200 à 9000, de l'alcool polyvinylique et de la polyvinyl pyrrolidone, à raison de 0,1 à 100 mg/l.

2. Bain selon la revendication 1 contenant de 0,3 à 30 mg/l du stabilisant.

3. Bain selon la revendication 1 ou la revendication 2 dans lequel le composé d'or soluble dans l'eau est sélectionné parmi le sulfite d'or sodium, le sulfite d'or potassium, le sulfite d'or ammonium, le cyanure d'or sodium, le cyanure d'or potassium, le chloroaurate de sodium et le chloroaurate de potassium.

4. Bain selon l'une quelconque des revendications précédentes dans lequel le composé d'or soluble dans l'eau est présent à raison de 2 à 8 g/l de l'ion d'or.

5. Bain selon l'une quelconque des revendications précédentes dans lequel d'agent complexant est sélectionné parmi le sulfite de sodium, le sulfite de potassium, le sulfite d'ammonium, le cyanure de sodium, le cyanure de potassium, le thiosulfate de sodium, le thiosulfate de potassium, le thiosulfate d'ammonium, l'EDTA, l'acide nitrilotriacétique, les acides phosphoniques organiques et leurs sels, l'acide citrique et ses sels, l'acide tartrique et ses sels, la glucono-δ-lactone, des gluconates et des acides aminés essentiels et leurs sels.

6. Bain selon l'une quelconque des revendications précédentes dans lequel l'agent complexant est présent à raison de 20 à 150 g/l.

7. Bain selon l'une quelconque des revendications précédentes dans lequel l'agent réducteur est présent à raison de 5 à 70 g/l.

8. Bain selon l'une quelconque des revendications précédentes qui comprend un composé azoté.

9. Bain selon la revendication 8, dans lequel le composé azoté est sélectionné parmi

   - de l'ammoniaque et des sels d'ammonium, à raison de 1 à 200 g/l;

   - des acides aminocarboxyliques, des acides iminocarboxyliques, des amines, des alcools aminés, des amines aromatiques, des composés hétérocycliques, des acides sulfoniques azotés et des pyridines solubles dans l'eau présents à raison de 0,01 à 100 g/l.

10. Bain selon l'une quelconque des revendications précédentes qui contient de l'ion de plomb et/ou de l'ion de thallium.

11. Bain selon la revendication 10 dans lequel l'ion de plomb et/ou l'ion de thallium est présent à raison de 0,1 à 50 mg/l.

12. Bain selon l'une quelconque des revendications précédentes dans lequel le composé d'or soluble dans l'eau n'est pas du cyanure, le bain comprenant de plus de 0,01 à 2 g/l de l'ion de cyanure.

13. Méthode de placage d'or non électrolytique dans laquelle une portion métallique sur une base de céramique est immergée dans un bain selon l'une quelconque des revendications précédentes pour déposer un revêtement d'or sur la portion métallique.

14. Dans une méthode comprenant un placage non électrolytique d'or sur une portion métallique d'une base de céramique, d'un bain comprenant

   (a) un composé d'or soluble dans l'eau à raison de 1 à 20 g/l de l'ion d'or;
   (b) un agent complexant, à raison de 5 à 200 g/l; et
   (c) un agent réducteur sélectionné parmi des hydrazines, l'acide ascorbique et ses sels solubles dans l'eau, le triméthylaminoborane et le diméthylaminoborane, à raison de 1 à 100 g/l,

   l'utilisation de

   (d) un stabilisant sélectionné parmi des polyalkylène glycols ayant un poids moléculaire compris entre 200 et 9000, de l'alcool polyvinylique et de la polyvinyl pyrrolidone, à raison de 0,1 à 100 mg/l, pour retenir l'étalement du placage d'or résultant, de la portion métallique sur la base de céramique.